# EUROPÄISCHE PATENTSCHRIFT

(11) **EP 2 603 774 B1**
(45) Veröffentlichungstag und Bekanntmachung des Hinweises auf die Patenterteilung: **18.03.2015**
(21) Anmeldenummer: 11752133.6
(22) Anmeldetag: 03.08.2011
(51) Int. Cl.: G01D 5/14, G01D 5/16, G01L 5/22, G01R 33/038, G01L 3/10, B62D 15/02, G01D 21/02, B62D 6/10

(54) **VORRICHTUNG MIT EINEM DREHMOMENTSENSOR UND EINEM DREHWINKELSENSOR**
DEVICE COMPRISING A TORQUE SENSOR AND A ROTATION ANGLE SENSOR
DISPOSITIF COMPORTANT UN CAPTEUR DE COUPLE ET UN CAPTEUR D'ANGLE DE ROTATION

(30) Priorität: 09.08.2010 DE 102010033769
(43) Veröffentlichungstag der Anmeldung: 19.06.2013
(73) Patentinhaber: Valeo Schalter und Sensoren GmbH, 74321 Bietigheim-Bissingen (DE)
(72) Erfinder: FROEHLICH, Ekkehart, 74226 Nordheim (DE); RUETZ, Christian, 71636 Ludwigsburg (DE); SCHOEPE, Roman, 75433 Maulbronn (DE); JEREMS, Frank, 74369 Loechgau (DE); HADOBAS-ROESSEL, Katalin, 74321 Bietigheim-Bissingen (DE)
(86) Internationale Anmeldenummer: PCT/EP2011/063342
(87) Internationale Veröffentlichungsnummer: WO 2012/019947

(56) Entgegenhaltungen:
- EP-A1- 2 133 677
- DE-A1- 10 344 043
- DE-A1-102005 038 516
- DE-A1-102009 033 242
- DE-A1-102009 038 256
- US-A1- 2009 230 953

## Beschreibung

Die Erfindung betrifft eine Vorrichtung, insbesondere für einen Kraftwagen, mit einem Drehmomentsensor zur Bestimmung eines Drehmoments einer Lenkwelle und einem Drehwinkelsensor zur Bestimmung eines Drehwinkels der Lenkwelle.

Aus der DE 195 06 938 A1 ist eine Lenkwinkelsensor bekannt, der eine absolute Winkelmessung auch bei mehreren Umdrehungen der Lenkwelle erlaubt. Die Drehbewegung an der Welle wird auf zwei Zahnräder übertragen, in die je ein Magnet eingebaut ist. Deren Magnetisierung verläuft in der Zahnradebene und wird von magnetoresistiven Sensoren erfasst. Jedem der beiden Zahnräder ist hierbei je ein Sensor zugeordnet, der über den Zahnrädern in einer zweiten Ebene angeordnet ist. Die Sensoren sind dazu ausgebildet, die jeweiligen Magnetfeldverläufe zu erkennen. Der Lenkwinkel kann dann aus den beiden gemessenen Winkeln berechnet werden.

Auch die DE 199 62 241 A1 beschreibt eine Anordnung zum Erfassen eines absoluten Lenkwinkels, in der zwei Drehstellungssensoren an eine Lenkwelle gekoppelt sind. Über die Phasendifferenz der gemessenen Drehstellungswinkel wird dann der absolute Lenkwinkel bestimmt. Die Sensoren umfassen einen drehbar gelagerten Magneten, der zusammen mit der Lenkwelle um eine zu dieser Welle parallele Achse rotiert. Ferner enthalten die Sensoren ein stationäres Bauteil, das in Abhängigkeit des Magnetfeldes elektrische Ausgangssignale erzeugt und radial zur Rotationsachse des Magneten angeordnet ist.

Die in diesen Anordnungen typischerweise eingesetzten Permanentmagnete sind scheibenförmig und aus einem kunststoffgebundenen Selten-Erd-Material gefertigt. Zudem verläuft die Magnetisierung in der Regel diametral. Beide Aspekte tragen dazu bei, dass das Magnetfeld räumlich sehr ausgedehnt ist (typischerweise um das 4- bis 5-fache des Durchmessers des Permanentmagneten) und zu unerwünschten Störungen in einem benachbarten zweiten Sensorsystem führt. Hierdurch ergeben sich unerwünschte Messungenauigkeiten.

Es ist Aufgabe der Erfindung, die Messgenauigkeit in einer Vorrichtung mit einem Drehmomentsensor und einem Drehwinkelsensor zu verbessern.

Diese Aufgabe wird durch eine Vorrichtung, welche die Merkmale des Patentanspruchs 1 aufweist, gelöst.

Die erfindungsgemäße Vorrichtung umfasst zumindest einen Drehmomentsensor sowie eine Drehwinkelsensor. Der Drehmomentsensor ist dazu ausgelegt, das Drehmoment einer Lenkwelle, insbesondere einer Lenkwelle eines Kraftwagens, zu messen. Analog hierzu ist der Drehwinkelsensor dazu ausgelegt, den Drehwinkel der Lenkwelle zu bestimmen. Die Lenkwelle ist hierfür insbesondere so an den Drehmomentsensor und den Drehwinkelsensor gekoppelt, dass ihre Drehbewegung auf die Sensoren übertragen wird und dort zur Änderung eines Signals führt. Der Drehmomentsensor arbeitet unter Zuhilfenahme eines Magnetfeldes. Er umfasst hierfür eine Magneteinrichtung, welche es erlaubt, das Drehmoment in Abhängigkeit von der Stärke des Magnetfeldes und/oder der Richtung bzw. Orientierung des Magnetfeldes zu bestimmen. Der Drehwinkelsensor umfasst einen Permanentmagneten und einen Magnetfelddetektor, wobei der Magnetfelddetektor dazu ausgebildet ist, die Richtung des insbesondere vom Permanentmagneten erzeugten Magnetfeldes zu erfassen. Der Magnetfelddetektor ist also insbesondere in der Lage, nicht nur die Stärke bzw. absolute Größe eines Magnetfeldes zu messen, sondern auch die Richtung bzw. Orientierung eines magnetischen Flusses zu detektieren. Er kann folglich die Richtung magnetischer Feldlinien bestimmen und so ermitteln, wo sich magnetische Nord- und Südpole befinden. Der Drehmomentsensor und der Drehwinkelsensor sind benachbart zueinander angeordnet, und zwar insbesondere entlang der Längserstreckung der Lenkwelle. Die erfindungsgemäße Vorrichtung ist ferner dadurch gekennzeichnet, dass sich zwischen Drehmomentsensor und Drehwinkelsensor eine Abschirmvorrichtung für Magnetfelder befindet und/oder der Permanentmagnet des Drehwinkelsensors zweipolig axial mit einer Hauptachse ausgebildet ist.

Gemäß der ersten Alternative mit der magnetischen Abschirmvorrichtung ist eine zumindest teilweise Entkopplung der Magnetfelder beider Sensoren möglich. Beispielsweise kann die Abschirmvorrichtung vermeiden, dass ein vom Drehmomentsensor erzeugtes Magnetfeld den Magnetfelddetektor des Drehwinkelsensors beeinflusst, die Drehwinkelmessung stört und zur Verfälschung von Messergebnissen führt. Insbesondere ist die Abschirmvorrichtung jedoch dazu ausgelegt, das Magnetfeld des Permanentmagneten des Drehwinkelsensors zumindest teilweise so abzuschirmen, als dass die Messeigenschaften des Drehmomentsensors nicht nachteilig beeinflusst werden. Die Abschirmvorrichtung erlaubt es, Drehmomentsensor und Drehwinkelsensor sehr nah zueinander anzuordnen, ohne dass eine nachteilige gegenseitige Beeinflussung stattfände. Zwei auf Magnetbasis arbeitende Sensorensystem lassen sich folglich auf sehr engem Bauraum gleichzeitig realisieren. Dies erlaubt eine sehr dichte Integration beider Sensorsystem in der Vorrichtung und damit ein baulich sehr kompaktes Gerät.

Gemäß der zweiten Alternative weist der Permanentmagnet des Drehwinkelsensors eine sehr definierte Magnetisierung auf: Er ist zweipolig axial mit einer Hauptachse ausgebildet. Ein zweipolig axial magnetisierter Permanentmagnet zeichnet sich durch unterschiedlich magnetisierte Sektoren bzw. Bereiche in seinem Inneren aus. Ein Teilbereich des Magneten gliedert sich in einen magnetischen Nord- und einen magnetischen Südpol, wobei beide Pole entlang der Hauptachse des Magneten ausgebildet sind. In dem hierzu verschiedenen zweiten Teilbereich des Permanentmagneten liegen wiederum magnetischer Nord- und magnetischer Südpol in axialer Richtung bezüglich der Hauptachse vor. Die Orientierung des Magnetfeldes ist hier jedoch genau entgegengesetzt zur Orientierung des Magnetfeldes im ersten Teilbereich. Zumindest im Inneren des Permanentmagneten verlaufen die magnetischen Feldlinien in beiden Teilbereichen parallel zur Hauptachse. Beispielsweise ist der zweipolig axial magnetisierte Permanentmagnet in Form eines geraden Zylinders mit einer Grund- und einer Deckfläche ausgebildet. Grund- und Deckfläche stehen dann senkrecht zur Hauptachse, welche parallel zur Manteloberfläche des Zylinders verläuft. In einem ersten Teil der Grundfläche ist ein magnetischer Südpol ausgebildet und in einem ersten Teil der Deckfläche, welcher dem ersten Teil der Grundfläche bezüglich der Hauptachse senkrecht gegenüber liegt, ist ein magnetischer Nordpol ausgebildet. Zudem ist in einem zweiten Teil der Grundfläche ein magnetischer Nordpol ausgebildet und in einem zweiten Teil der Deckfläche, welcher dem zweiten Teil der Grundfläche bezüglich der Hauptachse senkrecht gegenüber liegt, ein magnetischer Südpol ausgebildet. Insbesondere können die Grund- und die Deckfläche des zylinderförmigen Permanentmagneten kreisrund ausgebildet sein, wobei der erste und zweite Teil der jeweiligen Flächen durch die Halbkreise begrenzt ist, die gemeinsam den Vollkreis der jeweiligen Fläche bilden.

Die geringe Beabstandung der Magnetpole bedingt ein räumlich gering ausgedehntes Streufeld außerhalb des Permanentmagneten. Dies unterscheidet einen solch zweipolig axial magnetisierten Permanentmagneten insbesondere von einem diametral magnetisierten Permanentmagneten, welcher ein räumlich ausgedehntes Streufeld besitzt. Die zweipolig axiale Magnetisierung führt zu einer Konzentration bzw. Verdichtung von magnetischen Feldlinien in einem vergleichsweise geringen Raumvolumen. Hierdurch lassen sich magnetische Störeinflüsse im benachbarten Drehmomentsensor reduzieren bzw. vollständig vermeiden. Zudem stehen hohe magnetische Flussdichten zur Verfügung, welche die Signalstärke im Magnetfelddetektor verbessern. Die hohen magnetischen Felddichten verhindern also einerseits Messfehler im Drehmomentsensor und erhöhen andererseits die Messgenauigkeit im Drehwinkelsensor.

Vorzugsweise ist der Permanentmagnet des Drehwinkelsensors in einem drehbar gelagerten Rad angebracht. Das Rad, bei dem es sich insbesondere um ein Zahnrad handelt, ist hierbei drehbar um eine Rotationsachse gelagert. Die feste Verbindung des Permanentmagneten mit dem Rad bedingt, dass eine Drehbewegung des Rades direkt zu einer Rotation des Permanentmagneten führt. Bestimmte Drehwinkel des Rades um seine Rotationsachse führen dann zu identischen Drehwinkeln des Permanentmagneten. Diese Ausführungsform erlaubt eine einfache und unkomplizierte Übertragung von Drehbewegungen auf den Permanentmagneten, insbesondere dann, wenn das Rad mit der Lenkwelle drehbar gekoppelt ist. Dann wird eine Drehbewegung der Lenkwelle unmittelbar eine Rotation des Permanentmagneten verursachen. Bei bekanntem Übersetzungsverhältnis zwischen Lenkwelle und Rad lässt sich folglich jedem Drehwinkel der Lenkwelle eindeutig ein Rotationswinkel des Permanentmagneten zuordnen. Bei geeignet magnetisierten Permanentmagneten entspricht dann einer bestimmten Drehstellung der Lenkwelle eine charakteristische Orientierung der magnetischen Feldlinien des Permanentmagneten.

Besonders bevorzugt ist es hierbei, wenn die Drehachse der Lenkwelle parallel zur Rotationsachse des Rades verläuft. Dann lässt sich eine besonders direkte und unkomplizierte Ankopplung des Rades an die Lenkwelle erreichen. Dies ist besonders dann der Fall, wenn es sich bei dem Rad um ein Zahnrad handelt, welches direkt mit einem zweiten Zahnrad zusammenwirkt, das an der Lenkwelle radial umlaufend befestigt ist. Dann liegen das Zahnrad der Lenkwelle und das Zahnrad mit dem Permanentmagneten in einer gemeinsamen Ebene und drehen sich um parallel zueinander stehende Dreh- bzw. Rotationsachsen. Die geringe Anzahl mechanischer Komponenten führt zu einer geringen Fehleranfälligkeit des Drehwinkelsensors und erlaubt eine direkte und unproblematische Übertragung der Drehbewegung der Lenkwelle auf den Permanentmagneten.

Besonders bevorzugt ist es, wenn der Permanentmagnet des Drehwinkelsensors zweipolig axial magnetisiert ist und im Rad so angebracht ist, dass seine Hauptachse parallel zur Rotationsachse des Rades verläuft. Dies ist insbesondere dann der Fall, wenn der Permanentmagnet zylinder- bzw. scheibenförmig und gegebenenfalls rotationssymmetrisch um die Zylinder- bzw. Hauptachse ist. Wenn das Rad um seine Rotationsachse rotiert, dreht sich folglich auch der Permanentmagnet um seine Zylinderhauptachse. Dann ist eine sehr symmetrische Situation gegeben, bei der auch die magnetischen Feldlinien des Permanentmagneten in definierter Art und Weise um eine gemeinsame Drehachse rotieren. Der Drehbewegung des Rades (und damit der Drehbewegung der Lenkwelle) entspricht dann eine bestimmte Orientierung der äußeren magnetischen Feldlinien des Permanentmagneten, welche über den Magnetfelddetektor festgestellt werden kann. Der Drehwinkel der Lenkwelle kann auf diesem Wege besonders unkompliziert gemessen werden.

Gemäß einer besonders bevorzugten Ausführungsform ist der Permanentmagnet des Drehwinkelsensors zweipolig axial mit einer Hauptachse ausgebildet und der Magnetfelddetektor des Drehwinkelsensors so angeordnet, dass er entlang der Richtung dieser Hauptachse liegt. Permanentmagnet und Magnetfelddetektor sitzen dann auf einer gemeinsamen Achse einander gegenüber. Beispielsweise ist der Permanentmagnet zylinderförmig mit einer Deckfläche, die in einer ersten Ebene liegt. Der Magnetfelddetektor liegt dann in einer hierzu parallelen zweiten Ebene der Deckfläche gegenüber. Die aus der Deckfläche des Permanentmagneten austretenden Magnetfeldlinien durchsetzen den Magnetfelddetektor und erlauben die Detektion ihrer Vorzugsrichtung. Durch den Verlauf der magnetischen Feldlinien oberhalb der Deckfläche (also außerhalb des Permanentmagneten) ist eine definierte Feldrichtung parallel zur Deckfläche vorgegeben. Diese Feldrichtung ist dann abhängig von der Drehwinkelstellung des Permanentmagneten um seine Hauptachse. Sie kann problemlos von dem feldrichtungssensitiven Magnetfelddetektor erfasst werden. Damit erlaubt diese spezielle Relativanordnung von Permanentmagnet und Magnetfelddetektor eine besonders genaue, einfache und zuverlässige Messung der Orientierung des Magnetfeldes des Permanentmagneten.

Weiterhin ist es bevorzugt, dass der Magnetfelddetektor auf der dem Drehmomentsensor abgewandten Seite des Permanentmagneten angeordnet ist. Drehmomentsensor und Magnetfelddetektor sind folglich auf einander gegenüber liegenden Seiten des Permanentmagneten positioniert. Dies erlaubt eine besonders effektive Abschirmung des Magnetfeldes des Drehwinkelsensors vom Drehmomentsensor durch die zwischen den Sensoren angeordnete Abschirmvorrichtung. Auf der dem Magnetfelddetektor zugewandten Seite des Permanentmagneten ist das Magnetfeld erwünscht und notwendig; auf der gegenüber liegenden Seite jedoch überflüssig und sogar störend. Es kann nämlich den ebenfalls magnetisch arbeitenden Drehmomentsensor nachteilig beeinflussen. Dann ist es zweckmäßig, dieses unerwünschte Magnetfeld mithilfe der Abschirmvorrichtung daran zu hindern, zum Drehmomentsensor vorzudringen. Dadurch, dass die Abschirmvorrichtung und der Magnetfelddetektor auf unterschiedlichen, einander gegenüber liegenden Seiten des Permanentmagneten angeordnet sind, lassen sich Mess- und Abschirmfunktionalität klar voneinander trennen.

Weiterhin ist es bevorzugt, wenn der Permanentmagnet des Drehwinkelsensors zweipolig axial mit einer Hauptachse ausgebildet ist und zusätzlich eine Mulde aufweist. Diese Mulde führt dann zu einer zumindest teilweisen Parallelisierung der Magnetfeldlinien, welche den magnetischen Fluss außerhalb des Permanentmagneten charakterisieren. Die Mulde ist insbesondere in der Grund- und/oder Deckfläche eines scheiben- bzw. zylinderförmigen Permanentmagneten ausgebildet. Die Mulde ist eine Ausnehmung, die sowohl von Bereichen mit magnetischem Nordpol als auch Bereichen mit magnetischem Südpol begrenzt sein kann. Durch die zweipolig axiale Magnetisierung des Permanentmagneten kommt es allgemein zu einer Konzentration der magnetischen Feldlinien auf einen relativ kleinen Raumbereich. Diese Konzentration der Feldlinien bedingt eine Erhöhung der die Magnetfeldstärke bzw. -richtung charakterisierenden Gradienten, was sich negativ auf das Toleranzverhalten des Permanentmagneten bezüglich seiner räumlichen Positionierung auswirken kann. Insbesondere in von der Hauptachse weiter entfernten Bereichen verlaufen die Magnetfeldlinien nicht mehr parallel zueinander, sondern sind gekrümmt. Diese gekrümmten Feldlinien können zu Messungenauigkeiten bei der Bestimmung des Drehwinkels durch den Magnetfelddetektor führen. Deshalb ist es vorteilhaft, die Topologie des Permanentmagneten durch eine geeignete Ausnehmung bzw. Mulde so zu formen, dass es zu einer wenigstens bereichsweisen Parallelisierung der Magnetfeldlinien außerhalb des Permanentmagneten kommt. Die Mulde bewirkt, dass die magnetischen Feldlinien zumindest in einem Teilbereich um die Hauptachse des Permanentmagneten parallel ausgerichtet sind. Ein weiterer Vorteil der Mulde besteht darin, dass die magnetischen Flussdichten für kleiner werdende Abstände zum Magnetfelddetektor nicht mehr so stark ansteigen, so dass das Risiko einer Übersteuerung des Magnetfelddetektors minimiert oder ausgeschaltet wird. Die genaue Form der Mulde ist auf die jeweiligen Bedingungen wie z. B. Exzentrizität oder Abstand zum Magnetfelddetektor anzupassen. Aus fertigungstechnischen Gründen ist eine rotationssymmetrische Muldenform denkbar. Besonders bevorzugt ist es jedoch, wenn die Mulde als Langloch oder als Segment eines Rotationsellipsoids ausgebildet ist. Dabei ist besonders bevorzugt, wenn die jeweils lange Achse des Langlochs bzw. Rotationsellipsoids auf der Polgrenze zwischen magnetischem Nord- und magnetischem Südpol liegt. Diese Muldenformen führen zu einer besonders ausgeprägten Parallelisierung der magnetischen Feldlinien. Auch andere Muldenformen bzw. Oberflächentopologien des Permanentmagneten sind denkbar.

Als besonders vorteilhaft hat es sich erwiesen, wenn die Mulde auf der Außenseite des Permanentmagneten ausgebildet ist, welche dem Magnetfelddetektor des Drehwinkelsensors zugewandt ist. Je homogener das Magnetfeld in der Umgebung des Magnetfelddetektors, desto geringer sind die potenziellen Messungenauigkeiten bei der Bestimmung der Magnetfeldrichtung. Dies ist besonders dann von Bedeutung, wenn Magnetfelddetektor und Permanentmagnet nicht perfekt symmetrisch bezüglich der Rotationsachse des Permanentmagneten angeordnet sind, also insbesondere dann, wenn die Hauptachse des Permanentmagneten nicht mit seiner Rotationsachse zusammenfällt. Dann kommt es bei Rotation des Permanentmagneten zu einer Taumelbewegung, welche zu einer Änderung der Relativposition zwischen Permanentmagnet und Magnetfelddetektor führt. Inhomogenitäten in der Magnetfeldorientierung können dann vom Magnetfelddetektor fälschlicherweise als Änderungen im Rotationswinkel des Permanentmagneten interpretiert werden. Homogene Magnetfelder, also Magnetfelder mit weitestgehend parallel verlaufenden magnetischen Feldlinien, reduzieren diese Fehlerursache und erlauben eine im Wesentlichen korrekte Drehwinkelbestimmung auch im Falle nicht ideal zueinander positionierter Permanentmagnete und Magnetfelddetektoren.

Vorzugsweise ist der Permanentmagnet des Drehwinkelsensors aus einem Ferrit gebildet, wenn der zweipolig axial magnetisiert ist. Aus dem Stand der Technik bekannte Drehwinkelsensoren mit Permanentmagneten verwenden kunststoffgebundene Selten-Erd-Materialien, welche zwar relativ teuer sind, jedoch hohe magnetische Feldstärken erzielen. Die Permanentmagnete sind dann in der Regel diametral magnetisiert. Durch die zweipolig axiale Magnetisierung gemäß einem Aspekt der vorliegenden Erfindung sind die Magnetfeldlinien auf einen kleineren Raumbereich konzentriert. Um hohe magnetische Flussdichten zu erreichen, sind folglich keine Selten-Erd-Materialien mehr erforderlich. Bereits kostengünstige Hart-Ferrite erzielen am Ort des Magnetfelddetektors ausreichend hohe magnetische Flussdichten.

Nach einem Aspekt der Erfindung ist zwischen Drehmomentsensor und Drehwinkelsensor eine Abschirmvorrichtung für Magnetfelder angeordnet. Vorzugsweise ist diese Abschirmvorrichtung von einem magnetisch leitfähigen Material, insbesondere Stahl, gebildet. Magnetisch leitfähige Materialien sind Materialien mit einer hohen magnetischen Permeabilität, welche sich vornehmlich bei ferromagnetischen Festkörpern findet. Insbesondere ferromagnetische Materialien, die neben einer hohen Permeabilität auch ein geringere Permanenz aufweisen (sogenannte weichmagnetische Werkstoffe) erlauben eine besonders effektive Abschirmung konstanter Magnetfelder. Eine solche Abschirmvorrichtung kann einfach und kostengünstig durch gestanzte Scheiben aus Normalstahlblech realisiert werden. Insbesondere kreisrunde Scheiben aus dem magnetisch leitfähigen Material erweisen sich als vorteilhaft. Sie sind dünn, schirmen magnetische Streufelder sehr effektiv ab, lassen sich unkompliziert herstellen und einfach in eine Vorrichtung mit den beschriebenen Sensorbaugruppen integrieren.

Es ist hierbei besonders bevorzugt, wenn die Abschirmvorrichtung bezüglich ihrer Größe auf ein Innenmaß des Permanentmagneten abgestimmt ist. Gemäß einer bevorzugten Ausführungsform ist der Permanentmagnet des Drehwinkelsensors zylinder- bzw. scheibenförmig mit einer kreisrunden Grundfläche vom Durchmesser d1. Dann ist eine ebenfalls im Querschnitt kreisrunde scheibenförmige Abschirmvorrichtung bevorzugt, deren Querschnitt einen Durchmesser d2 aufweist. d2 ist dann das m-fache von d1, wobei m Werte im Intervall von 1,0 bis 3,0 annehmen kann, also z. B. 1,0, 1,1, 1,2, 1,3, 1,4, 1,5, 1,6, 1,7, 1,8, 1,9, 2,0, 2,1, 2,2, 2,3, 2,4, 2,5, 2,6, 2,7, 2,8, 2,9 und 3,0. Insbesondere sind Werte für m im Intervall von 1,9 bis 2,2 bevorzugt, also z. B. 1,8, 1,9, 2,0, 2,1 und 2,2. Es sind also Abschirmvorrichtungen bevorzugt, welche kreisrund sind und in etwa den doppelten Durchmesser des scheibenförmigen Permanentmagneten aufweisen. Hierdurch lässt sich bei einerseits geringem Platzbedarf für die Abschirmvorrichtung dennoch eine sehr effektive Abschirmung des magnetischen Streufeldes erreichen.

Schließlich sind Vorrichtungen bevorzugt, bei der die Magnetfelddetektoren des Drehwinkelsensors nach dem Hall-Prinzip oder auf magnetoresistiver Basis arbeiten. Beide Sensortypen können als integrierte Schaltkreise klein, kostengünstig und mit hoher Zuverlässigkeit hergestellt werden. Bei beiden Systemen handelt es sich um etablierte Standardbauteile, die sich ökonomisch in der Vorrichtung implementieren lassen. Sowohl Hall- als auch magnetoresistive Sensoren erlauben eine sehr exakte Bestimmung der Magnetfeldrichtung.

Weitere Merkmale der Erfindung ergeben sich aus den Ansprüchen, den Figuren und der Figurenbeschreibung. Die vorstehend in der Beschreibung genannten Merkmale und Merkmalskombinationen als auch die in der Figurenbeschreibung genannten Merkmale und Merkmalskombinationen und/oder die in den Figuren alleine gezeigten Merkmale und Merkmalskombinationen, sind nicht nur in der jeweils angegebenen Kombination, sondern auch in anderen Kombinationen oder in Alleinstellung verwendbar, ohne den Rahmen der Erfindung zu verlassen.

Anhand von Ausführungsbeispielen wird die Erfindung im Folgenden näher erläutert. Es zeigen:
- Fig. 1: eine auseinander gezogene perspektivische Darstellung einer Vorrichtung mit einem Drehmomentsensor und einem Drehwinkelsensor gemäß einem Ausführungsbeispiel der Erfindung;
- Fig. 2: eine perspektivische Aufsicht auf die Vorrichtung der Fig. 1, wobei einzelne Bauteile zur besseren Darstellung des Drehwinkelsensors weggelassen sind;
- Fig. 3: eine auseinander gezogene perspektivische Darstellung der Vorrichtung der Fig. 1, wobei einzelne Bauteile zur besseren Darstellung weggelassen sind;
- Fig. 4: eine perspektivische Ansicht der Vorrichtung der Fig. 1 von unten;
- Fig. 5: eine Schnittdarstellung der Vorrichtung der Fig. 1;
- Fig. 6A: eine schematische Aufsicht auf einen diametral magnetisierten Scheibenmagneten nach dem Stand der Technik;
- Fig. 6B: eine schematische Schnittdarstellung gemäß Linie 6B-6B des Scheibenmagneten der Fig. 6A;
- Fig. 7A: eine schematische Aufsicht auf einen zweipolig axial magnetisierten Scheibenmagneten;
- Fig. 7B: eine schematische Schnittdarstellung gemäß Linie 7B-7B des Scheibenmagneten der Fig. 7A;
- Fig. 8: einen schematischen Verlauf der magnetischen Feldlinien des Scheibenmagneten der Fig. 7B;
- Fig. 9A: einen schematischen Verlauf der magnetischen Feldlinien des Scheibenmagneten der Fig. 7A in einer ersten Drehstellung des Scheibenmagneten;
- Fig. 9B: einen schematischen Verlauf der magnetischen Feldlinien des Scheibenmagneten der Fig. 7A in einer zweiten Drehstellung des Scheibenmagneten; und
- Fig. 9C: einen schematischen Verlauf der magnetischen Feldlinien eines Scheibenmagneten mit einer Mulde in der Drehstellung der Fig. 9B.

In den Figuren werden gleiche oder funktionsgleiche Elemente mit den gleichen Bezugszeichen versehen.

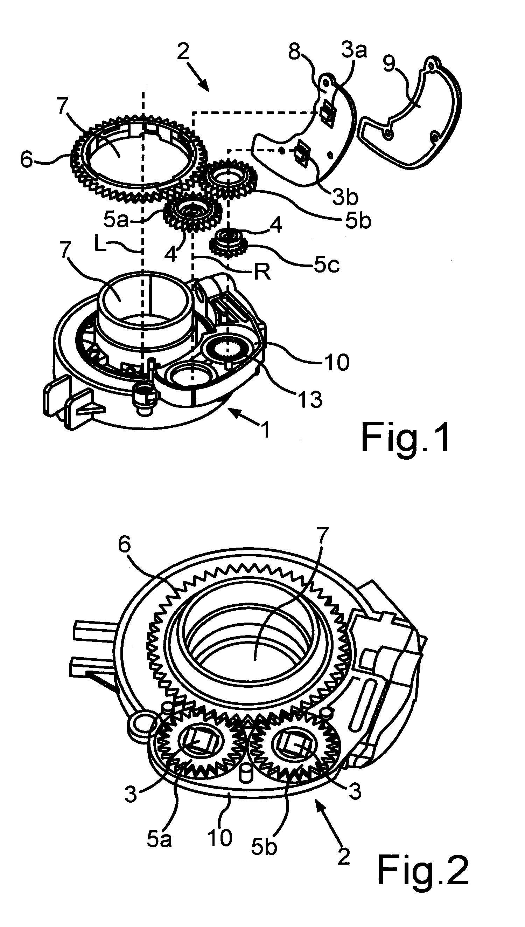

In Fig. 1 ist in einer auseinander gezogenen Darstellung bzw. teilweisen Explosionsdarstellung eine integrierte Sensorvorrichtung für ein Kraftfahrzeug mit einem magnetischen Drehmomentsensor 1 und einen magnetischen Drehwinkelsensor 2 gezeigt. Der Drehmomentsensor 1 ist mit einer Magneteinrichtung ausgebildet, die es erlaubt, über eine Änderung der Stärke und/oder Orientierung eines Magnetfeldes den Wert eines Drehmoments zu bestimmen. Der Drehmomentsensor 1 ist hierzu radial um eine Lenkwelle (nicht dargestellt) ausgebildet, welche durch eine zylinderförmige Aussparung 7 verläuft.

Direkt benachbart zum Drehmomentsensor 1 sind an der Lenkwelle die Komponenten des Drehwinkelsensors 2 angeordnet. Die Lenkwelle verläuft wiederum durch eine zylinderförmige Aussparung 7 in einem Rotor 6, welcher mit der Lenkwelle fest gekoppelt ist. Radial am Rotor 6 sind zwei Zahnräder 5a und 5b angeordnet, deren Zähne in jene des Rotors 6 greifen und auf diese Weise mit dem Rotor 6 drehbar gekoppelt sind. Im Zahnrad 5a ist ein scheibenförmiger Permanentmagnet 4 angeordnet. Die Rotationsachse R des Zahnrads 5a ist hierbei parallel zur Zylinderhauptachse des scheiben- bzw. zylinderförmigen Permanentmagneten 4. Ein zweites Teilsensorsystem des Drehwinkelsensors 2 umfasst das Zahnrad 5b, welches als Zwischenzahnrad mit einem Antriebszahnrad 5c drehbar gekoppelt ist. Das Zahnrad 5c enthält wiederum einen scheibenförmigen Permanentmagnet 4. Die Zahnräder 5a, 5b und 5c sind in einem Gehäuse 10 untergebracht und darin drehbar gelagert. Im Gehäuse 10 ist eine Innenverzahnung 13 vorhanden, an der das Zahnrad 5c entlang einer Zykloide abrollen kann. Die Bohrung des Zahnrads 5b ist hierzu exzentrisch ausgebildet. Ein Halter 8, welcher eine Platine oder ein Schaltkreis ist, und eine Abdeckung 9 sind gegenstückig zum Gehäuse 10 ausgebildet und schließen die Zahnräder 5 von oben her ein. Auf dem Halter 8 sind zwei Magnetfelddetektoren 3a und 3b befestigt. Im Ausführungsbeispiel handelt es sich bei ihnen um Mikrochip-basierte Hall-Sonden (Hall-IC). Alternativ können jedoch auch magnetoresistive Detektoren eingesetzt werden. Nachdem der Halter 8 gegenstückig auf dem Gehäuse 10 befestigt ist, kommen die Magnetfelddetektoren 3a und 3b gegenüber den Permanentmagneten 4 der Zahnräder 5a bzw. 5c zu liegen. Sie stehen dabei senkrecht zur Rotationsachse der Zahnräder 5a, 5b bzw. Permanentmagneten 4. Der Magnetfelddetektor 3a kommt auf der Drehachse des Zahnrads 5a zu liegen, während der Magnetfelddetektor 3b senkrecht zur Drehachse des Zahnrads 5b bzw. 5c sitzt. Die Anordnung der Magnetfelddetektoren 3 bezüglich den Zahnräder 5a, 5b kann auch sehr gut der Fig. 2 entnommen werden, da in dieser Darstellung der Halter 8 sowie die Abdeckung 9 fehlen.

Wie insbesondere in den Fig. 1 und 2 zu sehen ist, stehen alle Drehachsen parallel zueinander. Die Drehachse L der Lenkwelle, die durch die Aussparung 7 verläuft, steht z. B. parallel zur Rotationsachse R des Zahnrads 5a. Die Drehachse L ist auch Rotationsachse des Rotors 6.

In typischen Fahrzeuglenkungen muss ein Bereich von fünf bis sieben vollen Umdrehungen der Lenkwelle eindeutig erfasst werden. Um auch bei mehr als einer vollen Umdrehung der Lenkwelle den absoluten Drehwinkel eindeutig zu bestimmen, werden zwei Baugruppen eingesetzt. Die eine Baugruppe bildet einen Umdrehungssensor (Revolution Sensor, RS) und umfasst die Zahnräder 5b, 5c und den Magnetfelddetektor 3b. Es wird ein typisches Übersetzungsverhältnis von Rotor 6 zu Zahnrad 5c von 6:1 gewählt. Die andere Baugruppe dient der Feinbestimmung des Drehwinkels (Angle Sensor, AS) und umfasst im Wesentlichen das Zahnrad 5a mit dem Permanentmagneten 4 sowie den Magnetfelddetektor 3a. Für das Übersetzungsverhältnis von Rotor 6 zu Zahnrad 5a ist ein Wert von 1:3 gewählt. Aus den beiden mit den Magnetfelddetektoren 3a und 3b gemessenen Zahnradwinkeln kann dann in bekannter Weise über das Nonius-Prinzip der Drehwinkel der Lenkwelle unmittelbar berechnet werden. Geeignete Berechnungsverfahren hierfür sind aus dem Stand der Technik bekannt und beispielsweise in der DE 195 06 938 A1 und DE 199 62 241 A1 offenbart.

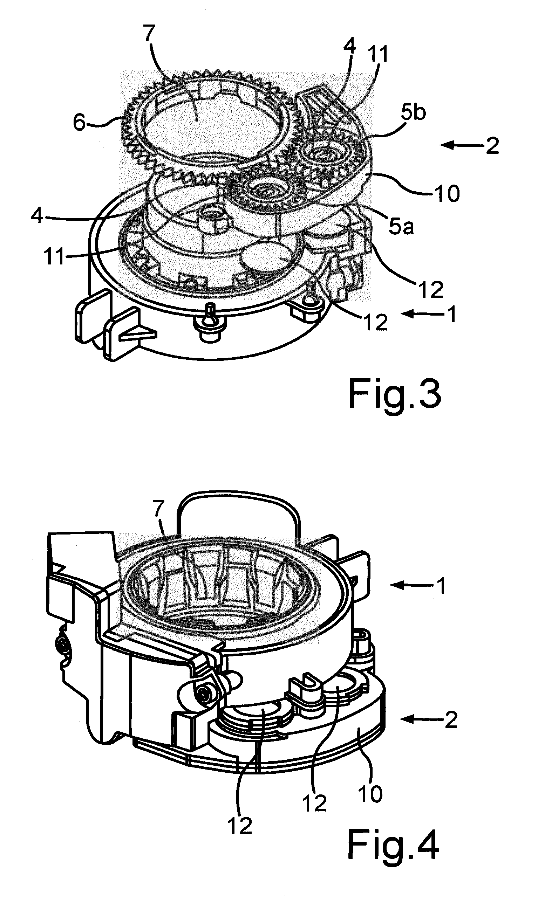

Die Explosionsdarstellung der Fig. 3 zeigt nochmals Details der Permanentmagnete 4 sowie des Gehäuses 10. Die Permanentmagnete 4 sind zylinderförmig mit kreisrunden Grundflächen und zentrosymmetrisch innerhalb der Zahnräder 5a, 5b angeordnet. Sie sind fest mit diesen verbunden, wobei die Zylinderhauptachse der Permanentmagnete 4 mit der Rotationsachse der Zahnräder 5a, 5b zusammenfällt. Zudem weisen die Permanentmagnete 4 an ihrer Deckfläche Mulden 11 auf, welche in Form eines Langlochs ausgebildet sind. Die Mulden 11 sitzen damit auf der den Magnetfelddetektoren 3 zugewandten Seite der Permanentmagneten 4.

Unterhalb der beiden Zahnräder 5a, 5b sind zwei scheibenförmige Abschirmbleche in Form von Stahlscheiben 12 angebracht, die im Ausführungsbeispiel direkt in das Gehäuse 10 eingespritzt sind. Alternativ zum Umspritzen können die Stahlscheiben 12 geklebt, per Warm- bzw. Ultraschallverstemmen befestigt oder in eine Tasche geschoben und geklipst werden. Die Stahlscheiben 12 schirmen das Magnetfeld der Permanentmagnete 4 gegenüber dem magnetfeldempfindlichen Drehmomentsensor 1 ab.

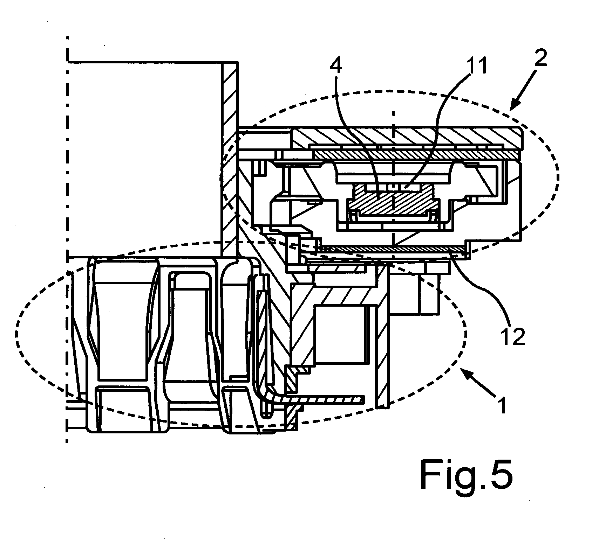

Auch aus den Darstellungen der Fig. 4 und 5 geht die relative Lage der Stahlscheiben 12 zwischen Drehmomentsensor 1 und Drehwinkelsensor 2 hervor. Aus Fig. 4 ist ersichtlich, dass die Stahlscheiben 12 in Taschen eingesetzt sind, welche sich an der Unterseite des Gehäuses 10 befinden. Wie aus Fig. 5 ersichtlich ist, werden die Stahlscheiben 12 gegenüber den Permanentmagneten 4 so angeordnet, dass sie in der Lage sind, deren Magnetfeld gegenüber dem Drehmomentsensor 1 abzuschirmen. Hierfür bietet sich beispielsweise eine gemeinsame zentrosymmetrische Anordnung von Permanentmagnet 4 und Stahlscheibe 12 an.

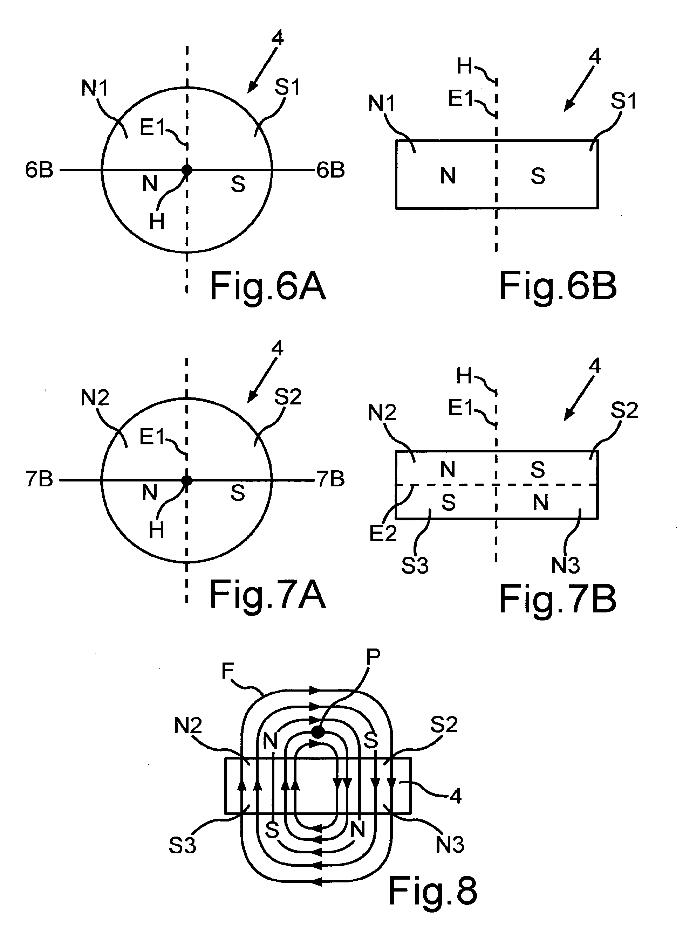

Eine zentrale Erkenntnis besteht darin, die Permanentmagnete 4 so zu gestalten, dass ihre Magnetfelder zu verbesserten Messeigenschaften in der Vorrichtung aus Drehmomentsensor 1 und Drehwinkelsensor 2 führen. Nach dem Stand der Technik sind die Magnete 4 üblicherweise scheibenförmig und hierbei diametral magnetisiert. Dies ist in den Fig. 6A und 6B dargestellt. Während Fig. 6A eine Aufsicht auf den scheibenförmigen Permanentmagneten 4 zeigt, gibt Fig. 6B den Permanentmagneten 4 im Querschnitt wieder. Die Permanentmagnete 4 sind im Wesentlichen zylinderförmig mit einer kreisrunden Grund- und Deckfläche. Diese haben typischerweise einen Durchmesser von 7 bis 9 Millimeter, wobei die Höhe des Zylinders 1,5 bis 2,5 Millimeter beträgt. Der Permanentmagnet 4 ist rotationssymmetrisch um eine Hauptachse H. Eine Ebene E1, die senkrecht zur Grund- bzw. Deckfläche des Permanentmagneten 4 durch dessen Hauptachse H verläuft, teilt diesen in einen Bereich N1 mit magnetischem Nordpol und einen Bereich S1 mit magnetischem Südpol. Hierdurch ergibt sich die typisch diametrale Magnetisierung. Innerhalb des Permanentmagneten 4 verlaufen die Magnetfeldlinien im Wesentlichen senkrecht zur Ebene E1. Solche scheibenförmigen Permanentmagnete 4 nach dem Stand der Technik werden in der Regel aus kunststoffgebundenen Selten-Erd-Materialien hergestellt. Hierdurch ergibt sich außerhalb des Permanentmagneten 4 ein räumlich sehr ausgedehntes Magnetfeld mit weit ausgreifenden Magnetfeldlinien, die vom Nordpol des Bereichs N1 zum Südpol des Bereichs S2 verlaufen. Die räumliche Ausdehnung des Magnetfeldes beträgt größenordnungsmäßig das vier- bis fünffache des Durchmessers des Permanentmagneten 4. Dieses ausgedehnte Magnetfeld kann zu Störungen im benachbarten Drehmomentsensor 1 führen.

Gemäß einem Aspekt der Erfindung ist deshalb der scheibenförmige Permanentmagnet 4 mit zweipolig axialer Magnetisierung ausgebildet. Eine Skizze eines solchen Permanentmagneten 4 ist in den Fig. 7A und 7B dargestellt. Durch eine senkrecht zur Grundfläche stehende Ebene E1, welche durch die Hauptachse H des Permanentmagneten 4 verläuft, ist dieser wiederum in zwei Hälften geteilt. Eine senkrecht zur Hauptachse H bzw. Ebene E1 verlaufende Ebene E2 untergliedert diese beiden Teilhälften wiederum in jeweils zwei Bereiche. Ein Bereich N2 mit magnetischem Nordpol steht einem Bereich S3 mit magnetischen Südpol gegenüber, wobei beide Bereiche durch die Ebene E2 getrennt sind und auf derselben Seite der Ebene E1 liegen. Analog hierzu stehen auf der anderen Seite der Ebene E1 die Bereiche N3 mit magnetischem Nordpol und S2 mit magnetischem Südpol einander bezüglich der Ebene E2 gegenüber.

Wie aus der schematischen Darstellung der Fig. 8 ersichtlich ist, verlaufen die magnetischen Feldlinien F innerhalb des zweipolig axial magnetisierten Permanentmagneten 4 näherungsweise in axialer Richtung, d. h. parallel zur Hauptachse H. Gegenüber dem diametral magnetisierten Permanentmagneten 4 der Fig. 6A und 6B liegen die Magnetpole hier enger beieinander. Es ergibt sich ein räumlich wesentlich geringer ausgedehntes Streufeld außerhalb des Permanentmagneten 4. Dies gilt insbesondere für einen Permanentmagneten 4, dessen Höhe in axialer Richtung erheblich geringer als sein Durchmesser ist, also für einen Permanentmagneten 4, der als dünne Scheibe ausgebildet ist. Die magnetischen Feldlinien F liegen insgesamt dichter bzw. konzentrierter und führen zu erhöhtem magnetischen Fluss in der Umgebung des Permanentmagneten 4. Beispielsweise ist an einem Messpunkt P der magnetische Fluss gegenüber einem diametral magnetisierten Permanentmagneten 4 erhöht. Würde der zweipolig axial magnetisierte Permanentmagnet 4 der Fig. 8 aus einem kunststoffgebundenen Selten-Erd-Material gefertigt, wäre die magnetische Flussdichte am Messpunkt P, an dem z. B. der Magnetfelddetektor 3 sitzt, höher als notwendig oder gar zu hoch. Es kann deshalb für das Magnetmaterial eine Qualität mit niedrigerer Remanenz gewählt werden, was zu einer deutlichen Kostenreduktion führt. Dennoch sind am Messpunkt P vergleichbare Werte für die magnetische Flussdichte wie im Falle des diametral magnetisierten Permanentmagneten 4 erreichbar. Durch die Konzentration der magnetischen Feldlinien F auf einen relativ kleinen Raumbereich werden zudem störende Einflüsse im benachbarten magnetischen Drehmomentsensor 1 vermieden. Im Ausführungsbeispiel der Fig. 7 bis 8 ist der Permanentmagnet 4 aus einem Hart-Ferrit mit niedrigerer Remanenz gefertigt.

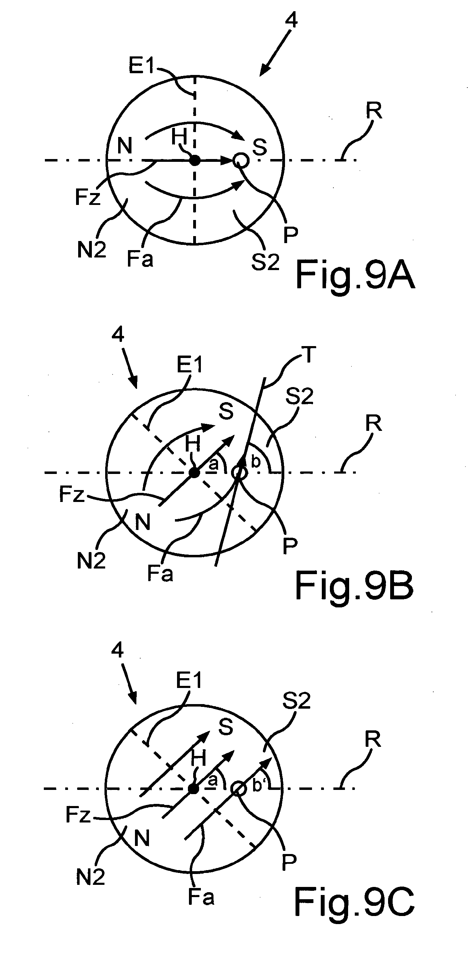

Wie aus der Darstellung der Fig. 3 hervorgeht, enthalten die Permanentmagnete 4 eine Mulde 11 in Form eines Langlochs. Diese Mulde 11 führt zu einer weiteren Erhöhung der Messgenauigkeit des Drehwinkelsensors 2, was anhand der Fig. 9A bis 9C erläutert werden soll: Die Fig. 9A und 9B zeigen einen zweipolig axial magnetisierten Permanentmagneten 4 in der Aufsicht analog zur Darstellung der Fig. 7A. Der dargestellte Permanentmagnet 4 besitzt keine Mulde 11. Eine virtuelle Referenzebene R enthält die Hauptachse H des Permanentmagneten 4 und steht in der Fig. 9A senkrecht auf der Ebene E1. Eine zentrale magnetische Feldlinie Fz, die vom Bereich N2 des magnetischen Nordpols zum Bereich S2 des magnetischen Südpols verläuft, ist geradlinig und steht senkrecht auf der Hauptachse H. Äußere magnetische Feldlinien Fa, die nicht durch die Hauptachse H verlaufen sind dagegen gekrümmt. Je weiter die Feldlinie Fa von der Hauptachse H entfernt verläuft, desto stärker gekrümmt ist sie. Dies führt zu Ungenauigkeiten bezüglich des detektierten Winkels an einem Messpunkt P.

Der Permanentmagnet 4 der Fig. 9B ist um einen Winkel a um die Hauptachse H rotiert. Die zentrale Feldlinie Fz schließt mit der Referenzebene R den tatsächlichen Rotationswinkel a ein. Am Messpunkt P wird jedoch die Richtung der äußeren Feldlinie Fa erfasst. Eine Tangentialebene T an die äußere Feldlinie Fa am Punkt P schließt mit der Referenzebene R einen Winkel b ein. Aufgrund der Krümmung der äußeren Feldlinie Fa ist der Winkel b größer als der tatsächliche Drehwinkel a. Es wird folglich der zu große Drehwinkel b detektiert und fälschlicherweise als tatsächlicher Drehwinkel a interpretiert.

Dieses unerwünschte Verhalten kann wesentlich verbessert bzw. ganz eliminiert werden, indem im Permanentmagneten 4 eine Mulde 11 vorgesehen wird. Die Mulde 11 bewirkt, dass auch die äußeren Feldlinien Fa in einem gewissen Bereich um die Hauptachse H parallel zur zentralen Feldlinie Fz ausgerichtet sind. Dies ist in Fig. 9C gezeigt. Der am Messpunkt P detektierte Winkel b' entspricht damit dem tatsächlichen Rotationswinkel a: a = b'. Zueinander parallele Feldlinien erhöhen folglich die Messgenauigkeit und verbessern die Drehwinkelbestimmung.

Die über die Mulde 11 realisierte Parallelisierung der magnetischen Feldlinien erlaubt es folglich, das Toleranzverhalten des Drehwinkelsensors 2 zu verbessern. Im Idealfall wird der Magnetfelddetektor 3 gegenüber dem Permanentmagneten 4 bzw. dem Zahnrad 5 stets so angeordnet sein, dass der Messpunkt P auf der Hauptachse H, die gleichzeitig Rotationsachse R des Permanentmagneten 4 ist, zu liegen kommt. Bei der tatsächlichen technischen Umsetzung wird eine solches ideales Verhalten nicht zu realisieren sein. Beispielsweise ist der Magnetfelddetektor 3 exzentrisch zur Rotationsachse R des Zahnrads 5 positioniert. Auch der Permanentmagnet 4 kann im Zahnrad 5 leicht versetzt angeordnet sein, so dass seine Hauptachse H nicht mehr mit der Rotationsachse R zusammenfällt. Die resultierende Taumelbewegung des Permanentmagneten 4 relativ zum Magnetfelddetektor 3 führt zu den in den Fig. 9A und 9B dargestellten Schwierigkeiten, die sich durch das Ausführungsbeispiel der Fig. 9C beheben lassen. Auch der Einsatz des Permanentmagneten 4 in einem Hypozykloidengetriebezahnrad kann zu dem beschriebenen Problem führen.

Sowohl der Einsatz von magnetfeldabschirmenden Stahlscheiben 12 einerseits als auch die spezielle Gestaltung der Permanentmagnete 4 andererseits bewirkt, dass sich die Messgenauigkeit der den Drehmomentsensor 1 und den Drehwinkelsensor 2 umfassenden Vorrichtung erheblich verbessern lässt. Zusätzlich können beide Sensoren auf sehr engem Bauraum integriert werden.

Im Hinblick auf die Ausgestaltung eines Permanentmagneten 4 kann dieser gemäß Fig. 1 bis 5 als ein zweipolig axialer ausgebildet sein und optional auch eine Mulde 11 aufweisen. Ist ein derartiger Magnet in der Sensorvorrichtung vorgesehen, so kann diese ohne die Abschirmung oder optional auch mit dieser ausgebildet sein. Ist ein Permanentmagnet 4 gemäß der Ausführung in Fig. 6A und 6B ohne zweipolig axiale Ausgestaltung vorgesehen, kann auch dieser optional die Mulde 11 aufweisen. Ist ein derartiger Magnet in der Sensorvorrichtung vorgesehen, ist insbesondere die Abschirmvorrichtung ausgebildet.

## Patentansprüche

1. Vorrichtung, insbesondere für einen Kraftwagen, mit einem Drehmomentsensor (1) zur Bestimmung eines Drehmoments einer Lenkwelle und einem Drehwinkelsensor (2) zur Bestimmung eines Drehwinkels der Lenkwelle, wobei
- der Drehmomentsensor (1) unter Zuhilfenahme eines Magnetfeldes arbeitet,
- der Drehwinkelsensor (2) einen Permanentmagneten (4) und einen Magnetfelddetektor (3, 3a, 3b) umfasst, wobei der Magnetfelddetektor (3, 3a, 3b) dazu ausgebildet ist, die Richtung eines Magnetfeldes zu erfassen, und
- der Drehmomentsensor (1) und der Drehwinkelsensor (2) benachbart angeordnet sind,
wobei
der Permanentmagnet (4) des Drehwinkelsensors (2) zweipolig axial mit einer Hauptachse (H) ausgebildet ist, derart dass
der Permanentmagnet zwei unterschiedlich magnetisierte Bereiche in seinem Inneren aufweist, wobei ein erster Teilbereich des Magneten sich in einen magnetischen Nord- und einen magnetischen Südpol gliedert und beide Pole entlang der Hauptachse des Magneten ausgebildet sind, und wobei in dem hierzu verschiedenen zweiten Teilbereich des Permanentmagneten wiederum magnetischer Nord- und magnetischer Südpol in axialer Richtung bezüglich der Hauptachse vorliegen, die Orientierung des Magnetfeldes im zweiten Teilbereich jedoch genau entgegengesetzt zur Orientierung des Magnetfeldes im ersten Teilbereich ist.

2. Vorrichtung nach Anspruch 1,
**dadurch gekennzeichnet, dass**
der Permanentmagnet (4) des Drehwinkelsensors (2) in einem um eine Rotationsachse (R) drehbar gelagerten Rad (5, 5a, 5b, 5c), insbesondere einem Zahnrad, angebracht ist.

3. Vorrichtung nach Anspruch 2,
**dadurch gekennzeichnet, dass**
das Rad (5, 5a, 5b, 5c) mit der Lenkwelle drehbar gekoppelt ist.

4. Vorrichtung nach Anspruch 2 oder 3,
**dadurch gekennzeichnet, dass**
die Drehachse (L) der Lenkwelle parallel zur Rotationsachse (R) des Rades (5, 5a, 5b, 5c) verläuft.

5. Vorrichtung nach einem der Ansprüche 2 bis 4,
**dadurch gekennzeichnet, dass**
der Permanentmagnet (4) des Drehwinkelsensors (2) zweipolig axial mit einer Hauptachse (H) ausgebildet ist und im Rad (5, 5a, 5b, 5c) so angebracht ist, dass die Hauptachse (H) parallel zur Rotationsachse (R) des Rades (5, 5a, 5b, 5c) verläuft.

6. Vorrichtung nach einem der vorhergehenden Ansprüche,
**dadurch gekennzeichnet, dass**
der Permanentmagnet (4) des Drehwinkelsensors (2) zweipolig axial mit einer Hauptachse (H) ausgebildet ist und der Magnetfelddetektor (3, 3a, 3b) des Drehwinkelsensors (2) entlang der Richtung der Hauptachse (H) angeordnet ist.

7. Vorrichtung nach Anspruch 6,
**dadurch gekennzeichnet, dass**
der Magnetfelddetektor (3, 3a, 3b) gegenüber der dem Drehmomentsensor (1) abgewandten Seite des Permanentmagneten (4) angeordnet ist.

8. Vorrichtung nach einem der vorhergehenden Ansprüche,
**dadurch gekennzeichnet, dass**
der Permanentmagnet (4) des Drehwinkelsensors (2) zweipolig axial mit einer Hauptachse (H) ausgebildet ist und eine zu einer zumindest teilweisen Parallelisierung der Magnetfeldlinien (F, Fz, Fa) außerhalb des Permanentmagneten (4) beitragende Mulde (11) aufweist.

9. Vorrichtung nach Anspruch 8,
**dadurch gekennzeichnet, dass**
die Mulde (11) als Langloch oder als Segment eines Rotationsellipsoids ausgebildet ist.

10. Vorrichtung nach Anspruch 8 oder 9,
**dadurch gekennzeichnet, dass**
die Mulde (11) in der dem Magnetfelddetektor (3, 3a, 3b) des Drehwinkelsensors (2) zugewandten Außenseite des Permanentmagneten (4) ausgebildet ist.

11. Vorrichtung nach einem der vorhergehenden Ansprüche,
**dadurch gekennzeichnet, dass**
der Permanentmagnet (4) des Drehwinkelsensors (2) zweipolig axial mit einer Hauptachse (H) ausgebildet ist und aus einem Ferrit gebildet ist.

12. Vorrichtung nach einem der vorhergehenden Ansprüche,
**dadurch gekennzeichnet, dass**
zwischen Drehmomentsensor (1) und Drehwinkelsensor (2) eine Abschirmvorrichtung (12) für Magnetfelder angeordnet ist und die Abschirmvorrichtung (12) von einem magnetisch leitfähigen Material, insbesondere Stahl, gebildet ist.

13. Vorrichtung nach Anspruch 12,
**dadurch gekennzeichnet, dass**
die Abschirmvorrichtung durch eine Scheibe (12), insbesondere eine kreisrunde Scheibe, aus dem magnetisch leitfähigen Material gebildet ist.

14. Vorrichtung nach Anspruch 12 oder 13,
**dadurch gekennzeichnet, dass**
der Permanentmagnet (4) des Drehwinkelsensors (2) zylinderförmig mit einer kreisrunden Grundfläche vom Durchmesser d1 ist und die Abschirmvorrichtung (12) zylinderförmig mit einer kreisrunden Grundfläche vom Durchmesser d2 ist und d2 = m * d1 ist, wobei m Werte im Intervall von 1,0 bis 3,0, insbesondere Werte im Intervall von 1,8 bis 2,2, annehmen kann.

15. Vorrichtung nach einem der vorhergehenden Ansprüche,
**dadurch gekennzeichnet, dass**
der Magnetfelddetektor (3, 3a, 3b) des Drehwinkelsensors (2) nach dem Hall-Prinzip oder auf magnetoresistiver Basis arbeitet.

## Claims

1. Apparatus, in particular for a motor vehicle, comprising a torque sensor (1) for determining a torque of a steering shaft and comprising a rotation angle sensor (2) for determining a rotation angle of the steering shaft, wherein
- the torque sensor (1) operates with the aid of a magnetic field,
- the rotation angle sensor (2) comprises a permanent magnet (4) and a magnetic field detector (3, 3a, 3b), wherein the magnetic field detector (3, 3a, 3b) is designed to detect the direction of a magnetic field, and
- the torque sensor (1) and the rotation angle sensor (2) are arranged adjacent to one another,
wherein
the permanent magnet (4) of the rotation angle sensor (2) is formed with two poles axial to a main axis (H) in such a way that
the permanent magnet has two regions of different magnetization in its interior, wherein a first subregion of the magnet is subdivided into a magnetic north pole and a magnetic south pole and the two poles are formed along the main axis of the magnet, and wherein there is once again a magnetic north pole and a magnetic south pole in the axial direction with respect to the main axis in the second subregion of the permanent magnet, which second subregion is different from the first subregion, but the orientation of the magnetic field in the second subregion is exactly opposite to the orientation of the magnetic field in the first subregion.

2. Apparatus according to Claim 1,
**characterized in that**
the permanent magnet (4) of the rotation angle sensor (2) is fitted in a wheel (5, 5a, 5b, 5c) which is mounted such that it can rotate about a rotation axis (R), in particular a gear wheel.

3. Apparatus according to Claim 2,
**characterized in that**
the wheel (5, 5a, 5b, 5c) is rotatably coupled to the steering shaft.

4. Apparatus according to Claim 2 or 3,
**characterized in that**
the rotation axis (L) of the steering shaft runs parallel to the rotation axis (R) of the wheel (5, 5a, 5b, 5c).

5. Apparatus according to one of Claims 2 to 4,
**characterized in that**
the permanent magnet (4) of the rotation angle sensor (2) is formed with two poles axial to a main axis (H) and is fitted in the wheel (5, 5a, 5b, 5c) such that the main axis (H) runs parallel to the rotation axis (R) of the wheel (5, 5a, 5b, 5c).

6. Apparatus according to one of the preceding claims,
**characterized in that**
the permanent magnet (4) of the rotation angle sensor (2) is formed with two poles axial to a main axis (H), and the magnetic field detector (3, 3a, 3b) of the rotation angle sensor (2) is arranged along the direction of the main axis (H).

7. Apparatus according to Claim 6,
**characterized in that**
the magnetic field detector (3, 3a, 3b) is arranged opposite the side of the permanent magnet (4) which is averted from the torque sensor (1).

8. Apparatus according to one of the preceding claims,
**characterized in that**
the permanent magnet (4) of the rotation angle sensor (2) is formed with two poles axial to a main axis (H) and has a recess (11) which contributes to an at least partial parallelization of the magnetic field lines (F, Fz, Fa) outside the permanent magnet (4).

9. Apparatus according to Claim 8,
**characterized in that**
the recess (11) is in the form of an elongate hole or in the form of a segment of a rotational ellipsoid.

10. Apparatus according to Claim 8 or 9,
**characterized in that**
the recess (11) is formed in the outer side of the permanent magnet (4) which faces the magnetic field detector (3, 3a, 3b) of the rotation angle sensor (2).

11. Apparatus according to one of the preceding claims,
**characterized in that**
the permanent magnet (4) of the rotation angle sensor (2) is formed with two poles axial to a main axis (H) and is formed from a ferrite.

12. Apparatus according to one of the preceding claims,
**characterized in that**
a shielding apparatus (12) for magnetic fields is arranged between the torque sensor (1) and the rotation angle sensor (2), and the shielding apparatus (12) is formed from a magnetically permeable material, in particular steel.

13. Apparatus according to Claim 12,
**characterized in that**
the shielding apparatus is formed by a disc (12), in particular a circular disc, which is composed of the magnetically permeable material.

14. Apparatus according to Claim 12 or 13,
**characterized in that**
the permanent magnet (4) of the rotation angle sensor (2) is cylindrical with a circular base area with the diameter d1, and the shielding apparatus (12) is cylindrical with a circular base area with the diameter d2, and d2 = m*d1, where m can assume values in the range of from 1.0 to 3.0, in particular values in the range of from 1.8 to 2.2.

15. Apparatus according to one of the preceding claims,
**characterized in that**
the magnetic field detector (3, 3a, 3b) of the rotation angle sensor (2) operates in accordance with the Hall principle or on a magnetoresistive basis.

## Revendications

1. Dispositif, en particulier pour un véhicule à moteur, comprenant un capteur de couple (1) pour déterminer un couple d'un arbre de direction et un capteur d'angle de rotation (2) pour déterminer un angle de rotation de l'arbre de direction,
- le capteur de couple (1) fonctionnant à l'aide d'un champ magnétique,
- le capteur d'angle de rotation (2) comprenant un aimant permanent (4) et un détecteur de champ magnétique (3, 3a, 3b), le détecteur de champ magnétique (3, 3a, 3b) étant réalisé pour détecter la direction d'un champ magnétique, et
le capteur de couple (1) et le capteur d'angle de rotation (2) étant disposés l'un à côté de l'autre,
l'élément permanent (4) du capteur d'angle de rotation (2) étant réalisé sous forme bipolaire axialement avec un axe principal (H), de telle sorte que
l'élément permanent présente en son intérieur deux régions magnétisées différemment, une première région partielle de l'élément se divisant en un pôle nord magnétique et un pôle sud magnétique et les deux pôles étant réalisés le long de l'axe principal de l'élément, et dans la deuxième région partielle de l'aimant permanent, différente de la première, étant à nouveau prévus un pôle nord magnétique et un pôle sud magnétique dans la direction axiale par rapport à l'axe principal, l'orientation du champ magnétique dans la deuxième région partielle étant toutefois exactement opposée à l'orientation du champ magnétique dans la première région partielle.

2. Dispositif selon la revendication 1,
**caractérisé en ce que**
l'aimant permanent (4) du capteur d'angle de rotation (2) est installé dans une roue (5, 5a, 5b, 5c) montée à rotation autour d'un axe de rotation (R), en particulier une roue dentée.

3. Dispositif selon la revendication 2,
**caractérisé en ce que**
la roue (5, 5a, 5b, 5c) est accouplée à rotation à l'arbre de direction.

4. Dispositif selon la revendication 2 ou 3,
**caractérisé en ce que**
l'axe de rotation (L) de l'arbre de direction s'étend parallèlement à l'axe de rotation (R) de la roue (5, 5a, 5b, 5c).

5. Dispositif selon l'une quelconque des revendications 2 à 4,
**caractérisé en ce que**
l'aimant permanent (4) du capteur d'angle de rotation (2) est réalisé sous forme bipolaire axialement avec un axe principal (H) et est installé dans la roue (5, 5a, 5b, 5c) de telle sorte que l'axe principal (H) s'étende parallèlement à l'axe de rotation (R) de la roue (5, 5a, 5b, 5c).

6. Dispositif selon l'une quelconque des revendications précédentes,
**caractérisé en ce que**
l'aimant permanent (4) du capteur d'angle de rotation (2) est réalisé sous forme bipolaire axialement avec un axe principal (H) et le détecteur de champ magnétique (3, 3a, 3b) du capteur d'angle de rotation (2) est disposé le long de la direction de l'axe principal (H).

7. Dispositif selon la revendication 6,
**caractérisé en ce que**
le détecteur de champ magnétique (3, 3a, 3b) est disposé en regard du côté de l'aimant permanent (4) opposé au capteur de couple (1).

8. Dispositif selon l'une quelconque des revendications précédentes,
**caractérisé en ce que**
l'aimant permanent (4) du capteur d'angle de rotation (2) est réalisé sous forme bipolaire axialement avec un axe principal (H) et présente un creux (11) contribuant à une parallélisation au moins partielle des lignes de champ magnétique (F, Fz, Fa) à l'extérieur de l'aimant permanent (4).

9. Dispositif selon la revendication 8,
**caractérisé en ce que**
le creux (11) est réalisé sous forme de trou oblong ou sous forme de segment d'une ellipsoïde de révolution.

10. Dispositif selon la revendication 8 ou 9,
**caractérisé en ce que**
le creux (11) est réalisé dans le côté extérieur de l'aimant permanent (4) tourné vers le détecteur de champ magnétique (3, 3a, 3b) du capteur d'angle de rotation (2).

11. Dispositif selon l'une quelconque des revendications précédentes,
**caractérisé en ce que**
l'aimant permanent (4) du capteur d'angle de rotation (2) est réalisé sous forme bipolaire axialement avec un axe principal (H) et est formé de ferrite.

12. Dispositif selon l'une quelconque des revendications précédentes,
**caractérisé en ce**
**qu'**entre le capteur de couple (1) et le capteur d'angle de rotation (2) est disposé un dispositif de blindage (12) pour des champs magnétiques et le dispositif de blindage (12) est formé par un matériau magnétiquement conducteur, en particulier de l'acier.

13. Dispositif selon la revendication 12,
**caractérisé en ce que**
le dispositif de blindage est formé par un disque (12), en particulier un disque circulaire, à partir du matériau magnétiquement conducteur.

14. Dispositif selon la revendication 12 ou 13,
**caractérisé en ce que**
l'aimant permanent (4) du capteur d'angle de rotation (2) est cylindrique avec une surface de base circulaire de diamètre d1 et le dispositif de blindage (12) est cylindrique avec une surface de base circulaire de diamètre d2 et d2 = m*d1, m pouvant prendre des valeurs dans un intervalle de 1,0 à 3,0, en particulier des valeurs dans un intervalle de 1,8 à 2,2.

15. Dispositif selon l'une quelconque des revendications précédentes,
**caractérisé en ce que**
le détecteur de champ magnétique (3, 3a, 3b) du capteur d'angle de rotation (2) fonctionne selon le principe de Hall ou par voie magnétorésistive.
